# EUROPÄISCHE PATENTSCHRIFT

(11) **EP 3 557 272 B1**
(45) Veröffentlichungstag und Bekanntmachung des Hinweises auf die Patenterteilung: **25.05.2022**
(21) Anmeldenummer: 18168539.7
(22) Anmeldetag: 20.04.2018
(51) Int. Cl.: G01R 33/54, G01R 33/28

(54) **VERFAHREN ZUM BETREIBEN EINER MRT-ANLAGE UND MRT-ANLAGE**
MRI SYSTEM AND METHOD FOR OPERATING AN MRI SYSTEM
PROCÉDÉ DE FONCTIONNEMENT D'UNE INSTALLATION IRM ET INSTALLATION IRM

(43) Veröffentlichungstag der Anmeldung: 23.10.2019
(73) Patentinhaber: Siemens Healthcare GmbH, 91052 Erlangen (DE)
(72) Erfinder: Kartäusch, Ralf, 91058 Erlangen (DE); Zeller, Mario, 91054 Erlangen (DE)

(56) Entgegenhaltungen:
- DE-A1-102009 038 139
- DE-A1-102014 206 636
- DE-A1-102014 211 958
- DE-A1-102014 226 053
- US-A1- 2013 023 753
- US-A1- 2016 231 396

## Beschreibung

Die Erfindung betrifft ein Verfahren zum Betreiben einer MRT-Anlage, also einer Anlage oder eines Geräts für die Magnetresonanztomographie (MRT). Die Erfindung betrifft weiterhin eine entsprechende MRT-Anlage, die für einen Betrieb gemäß dem Verfahren eingerichtet ist.

Magnetresonanztomographie-Untersuchungen eines Untersuchungsobjekts, insbesondere eines Patienten, können in diesem zu einer letztlich ungewollten Erwärmung und einer Nervenstimulation führen. Die Erwärmung wird durch eingestrahlte elektromagnetische Felder, also eine eingestrahlte Hochfrequenzleistung (HF-Leistung) bewirkt und ist quantifizierbar anhand der oder durch die spezifische Absorptionsrate (SAR, von englisch: "Specific Absorption Rate"). Die Nervenstimulation kann bewirkt werden durch eine Änderung eines oder mehrerer bei der Magnetresonanztomographie verwendeter magnetischer Gradientenfelder und wird daher auch als Gradientenstimulation bezeichnet. Die Änderungsrate, also die Geschwindigkeit, mit der sich eine Feldstärke der Gradientenfelder im Bereich des Patienten zeitlich verändert, wird fachüblich als "Slew Rate" bezeichnet.

Es bestehen verschiedene Ansätze, mit der Belastung des Patienten durch SAR umzugehen, wie sie beispielhaft in den Druckschriften US9625541B2, US6841999B2, US20150234019A1, US8547097B2, US20150061681A1, US20110263969A1 und US8461838B2 beschrieben sind.

Es kann ein Konflikt zwischen den Zielen einer möglichst guten Bildqualität und einer möglichst geringen Belastung des Patienten bestehen. So gibt es gesetzliche Regelungen und Grenzwerte sowohl für die SAR als auch für die Gradientenstimulation beziehungsweise die Slew Rate, die bei einer MRT-Untersuchung oder -Anwendung nicht überschritten werden dürfen. Gleichzeitig würden Einstellungen oder ein Betrieb der MRT-Anlage für eine optimale Bildqualität oftmals zu einer besonders hohen Erwärmung und/oder Gradientenstimulation führen.

Um MRT-Untersuchungen für den jeweiligen Anwender möglichst einfach und mit möglichst geringem Aufwand durchführbar zu machen und dabei gleichzeitig ein möglichst gutes Messergebnis, also eine möglichst gute Bildqualität, zu erreichen, gibt es heutzutage vorgefertigte Messabläufe. Ein solcher Messablauf kann ein Messprotokoll - kurz als Protokoll bezeichnet - oder mehrere sequenziell auszuführende Protokolle umfassen, wobei ein Protokoll wiederum einen oder mehrere einzelne Messpulse umfassen kann.

Es besteht die Problematik, dass die Grenzwerte für die SAR und die Gradientenstimulation abhängig sein können beispielsweise von der jeweiligen untersuchten, also abgebildeten, Körperregion und von einer Anatomie oder einem Körperbau des untersuchten Patienten. Dies kann durch standardisierte und starr vorgegebene Grenzwerte und Protokolle beziehungsweise Messabläufe nicht berücksichtigt werden. Werden beispielsweise Parameter und Parameterwerte eines Protokolls auf eine minimale Aufnahme- oder Messzeit bei einem normal, also durchschnittlich, proportionierten Patienten hin optimiert, so kann beispielsweise der Grenzwert für die SAR bei einem vergleichsweise muskulösen oder übergewichtigen Patienten überschritten werden. Um dies zu vermeiden, werden die Messabläufe beziehungsweise die darin verwendeten Parameter oder Parameterwerte oftmals konservativ ausgelegt, also im Hinblick auf ein worst-case-Szenario. Dies führt jedoch nachteilig bei vielen Patienten beispielsweise zu einer unnötig langen Messzeit und/oder zu einer nicht optimalen Bildqualität.

Bei heutigen MRT-Anlagen kann es jedoch besonders im klinischen Betrieb dennoch oft vorkommen, dass Grenzwerte für die SAR und die Gradientenstimulation überschritten werden. Für den Benutzer ist es dann heutzutage nur in einem sehr begrenzten Umfang möglich, einzelne Parameter eines Messablaufs einzustellen, was jedoch oftmals mit einem jeweiligen Behandlungs- oder Diagnoseziel für den jeweiligen Patienten in Konflikt steht. Beispielsweise kann die Option bestehen, eine Anzahl von abgebildeten Schichten von 20 auf 4 zu reduzieren oder eine Repetitionszeit (TR) zu verdoppeln. Derartige Einstellungen oder Anpassungen können zwar sicherstellen, dass die Grenzwerte nicht überschritten werden, stellen jedoch eine oftmals aus diagnostischer Sicht nicht praktikable Einschränkung der Untersuchung dar.

Die DE 10 2014 206 636 A1 beschreibt ein Verfahren und eine Vorrichtung zum Erstellen eines Protokolls einer Messsequenz für ein MRT-System. Dabei wird aus mehreren ähnlichen Teilmodulen eines identifiziert, dass die stärkste physiologische Belastung eines Patienten erzeugt. Sofern physiologische Grenzwerte nicht eingehalten werden, werden Einflussparameter der Messsequenz verändert.

Die DE 10 2009 038 139 A1 beschreibt ein Verfahren zur Steuerung einer MRT-Anlage gemäß einem vorab definierten Messprotokoll. Wird automatisch eine Nichteinhaltung eines Grenzwertes festgestellt, erfolgt durch das Messprotokoll eine Anpassung eines Aufnahmeparameters anhand einer protokollspezifischen Regel.

Aus der US 2013 / 0 023 753 A1 sind eine MRT-Anlage und eine SAR-Anpassungsmethode beim Abbilden eines Objekts mit mehreren Pulssequenzen bekannt. In einem SAR-Graph, welcher zeitliche Veränderungen vorhergesagter SAR-Werte für jede Pulssequenz anzeigt, werden Displaymodi wenigstens zweier Pulssequenzteile unterschiedlich dargestellt. Dies erfolgt auf Basis der vorhergesagten SAR-Werten oder abhängig von einer Austauschbarkeit der Pulssequenzen.

Die DE 10 2014 211 958 A1 ist befasst mit dem Bestimmen eines Sequenzprotokolls für eine MR-Anlage. Dabei wird abhängig von einem Übersichtsbild ein vorläufiges Sequenzprotokoll angepasst. Falls das angepasste Sequenzprotokoll eine vorbestimmte Stimulationsgrenze überschreitet, wird automatisch ein als änderbar bestimmter Parameter des Sequenzprotokolls entsprechend verändert.

Die DE 10 2014 226 053 A1 offenbart ein Verfahren zum Betrieb einer MR-Einrichtung. Dort ist ein Justagevorgang zur Anpassung von Betriebsparametern auf einen aktuellen Patienten vorgesehen. Ein Ergebnisdatum der Justage wird zur Ermittlung eines nicht auf die Pulsform eines HF-Pulses bezogenen Aufnahmeparameters berücksichtigt.

Aus der US 2016 0 / 231 396 A1 sind eine MRI-Anlage und ein Assistenzverfahren für ein Setzen eines Abbildungsparameters bekannt. Darin sollen Vorschläge für Abbildungsparameter angezeigt werden, welche in Bezug stehen mit einem Steuergegenstand und einer Richtung einer Veränderung der Abbildungsparameter. Wenn angezeigte Werte der Abbildungsparameter weiter verändert werden, werden basierend darauf Werte ausgewählter Steuergegenstände berechnet.

Aufgabe der vorliegenden Erfindung ist es, eine verbesserte Lösung von Konflikten zwischen einer möglichst guten Bildqualität in möglichst geringer Messzeit und einem Einhalten vorgegebener Grenzwerte zu ermöglichen.

Diese Aufgabe wird erfindungsgemäß durch die Gegenstände der unabhängigen Patentansprüche gelöst. Vorteilhafte Ausgestaltungen und Weiterbildungen der Erfindung sind in den abhängigen Patentansprüchen sowie in der Beschreibung und in den Zeichnungen angegeben.

Ein erfindungsgemäßes Verfahren dient zum Betreiben einer MRT-Anlage. Bei dem Verfahren wird ein geplanter Messablauf zum Untersuchen eines Untersuchungsobjekts, insbesondere eines Patienten, vorgegeben. Dies kann beispielsweise durch eine entsprechende Eingabe oder Auswahl eines Benutzers oder Anwenders über ein entsprechendes Benutzerinterface der MRT-Anlage erfolgen. Ebenso kann der geplante Messablauf von der MRT-Anlage beispielsweise automatisch aus einer Datenbank, einer elektronischen Patientenakte oder dergleichen ausgelesen werden.

In einem weiteren Verfahrensschritt wird dann für das jeweilige Untersuchungsobjekt mittels einer Berechnungseinrichtung der MRT-Anlage eine bei Verwendung des geplanten Messablaufs voraussichtlich auftretende spezifische Absorptionsrate (SAR) berechnet, die durch eine in das Untersuchungsobjekt eingestrahlte HF-Leistung bestimmt ist. Zusätzlich oder alternativ wird mittels der Berechnungseinrichtung eine bei Verwendung des geplanten Messablaufs in oder an dem Untersuchungsobjekt voraussichtlich auftretende Gradientenstimulation bestimmt, die durch eine Änderungsrate eines magnetischen Gradientenfeldes der MRT-Anlage in dem Untersuchungsobjekt erzeugt wird. Die Gradientenstimulation bezeichnet dabei eine elektromagnetisch verursachte Nervenstimulation des Patienten.

Die gemäß der entsprechenden Berechnung voraussichtlich auftretenden Werte für die SAR und/oder die Gradientenstimulation werden also vor Durchführung der eigentlichen Messung oder Untersuchung vorausberechnet oder simuliert. Dazu kann eine grundsätzlich bekannte, beispielsweise modellbasierte, Berechnungs- oder Simulationsmethode verwendet werden. Als Referenz sei hierzu beispielsweise verwiesen auf die Arbeiten "SAFE-Model - A New Method for Predicting Peripheral Nerve Stimulation in MRI" von Franz X. Hebrank und Matthias Gebhardt, "Effect of RF Pulse Sequence on Temperature Elevation for a Given Time-Average SAR" von Zhangwei Wang und Christopher M. Collis, doi: 10.1002/cmr.b.20172, und "RF Pulse Sequence and Temperature Elevation (in MRI)" von Chrisopher M. Collins (icnirp.org).

Falls die jeweilige Berechnung für den geplanten Messablauf ein Überschreiten eines jeweiligen vorgegebenen Grenzwertes für die SAR und/oder die Gradientenstimulation ergibt, wird auf Basis des bis dahin geplanten Messverlaufs automatisch ein geplanter modifizierter Messablauf erzeugt. Dazu wird der bisherige geplante Messverlauf mittels der Berechnungseinrichtung unter Einhaltung wenigstens einer vorgegebenen Randbedingung automatisch modifiziert. Diese wenigstens eine vorgegebene Randbedingung ist dabei verschieden von einem Unterschreiten des jeweiligen vorgegebenen Grenzwertes für die SAR und die Gradientenstimulation. Es werden hier also die jeweiligen berechneten Werte für die voraussichtlich auftretende SAR und/oder Gradientenstimulation mit dem jeweiligen vorgegebenen Grenzwert verglichen. Die Grenzwerte beziehungsweise der jeweilige vorgegebene Grenzwert können dazu beispielsweise in einer Speichereinrichtung oder Datenbank hinterlegt sein, die Teil der Berechnungseinrichtung oder mit dieser verbunden ist.

Besonders vorteilhaft können bei dem Berechnen außer dem geplanten Messablauf beispielsweise individuelle Eigenschaften oder Charakteristiken des jeweiligen Untersuchungsobjekts berücksichtigt werden, etwa dessen Größe, Gewicht, Körperbau, Körperfettanteil und/oder dergleichen mehr. Diese Daten können wie der geplante Messablauf ermittelt oder erfasst werden. Entsprechend können ebenso in der Speichereinrichtung oder Datenbank vorgegebene Grenzwerte für verschiedene Gewebetypen, Gewebezusammensetzungen, Patientenarten und/oder dergleichen mehr hinterlegt sein, die dann gemäß den erfassten individuellen Daten des jeweiligen Untersuchungsobjekts oder Patienten für den Vergleich mit den berechneten Werten abgerufen werden.

Die wenigstens eine vorgegebene Randbedingung umfasst eine Vorgabe, insbesondere eines Benutzers oder Anwenders, welche wenigstens ein minimal zu erfüllendes Kriterium für den modifizierten Messablauf spezifiziert. Durch die Randbedingung wird also sichergestellt, dass jeweilige Benutzerwünsche oder Anforderungen an die jeweilige MRT-Untersuchung bei dem automatischen Modifizieren des geplanten Messablaufs berücksichtigt werden. Dadurch wird vorteilhaft sichergestellt, dass der automatisch erzeugte modifizierte Messablauf auf den jeweiligen Anwendungsfall abgestimmt ist. So wird also die bisher oftmals auftretende Problematik wenig hilfreicher, da - wie erwähnt nicht praktikabler - Optionen bekannter MRT-Anlagen umgangen. Besonders vorteilhaft kann der geplante Messablauf so deutlich flexibler und detaillierter modifiziert werden, als dies bei bisherigen MRT-Anlage durch den Benutzer möglich ist, da die MRT-Anlage selbst intern Zugriff auf sämtliche Parameter, Einstellungen, steuerbaren Größen oder Einflussfaktoren, etc. der MRT-Anlage hat. Durch das automatische Modifizieren des geplanten Messablaufs kann also ein in einem, mehreren oder allen Parametern, Parameterwerten oder Eigenschaften modifizierter Messablauf bereitgestellt oder erzeugt werden, ohne dass hierfür ein entsprechend komplexes Benutzerinterface und entsprechendes technisches Fachwissen auf Seiten des Benutzers oder Anwenders notwendig ist. Anschließend erfolgt als Teil des erfindungsgemäßen Verfahrens ein automatisches iteratives Durchführen des Berechnens der für den jeweiligen modifizierten Messablauf voraussichtlich auftretenden SAR und/oder Gradientenstimulation und des automatischen Erzeugens des beziehungsweise eines jeweiligen neuen geplanten modifizierten Messablaufs. Dieses iterative Berechnen und Erzeugen wird zumindest so lange automatisch durchgeführt, bis das Berechnen ergibt, dass der jeweilige aktuelle modifizierte Messablauf den jeweiligen vorgegebenen Grenzwert für die SAR und/oder die Gradientenstimulation nicht überschreitet, also bei Verwendung oder Anwendung des jeweiligen modifizierten Messablaufs gemäß der Berechnung voraussichtlich nicht zum Überschreiten des jeweiligen Grenzwertes führt. Es wird also die Berechnung der voraussichtlich auftretenden SAR und/oder Gradientenstimulation für den vorgegebenen geplanten Messablauf durchgeführt, der geplante Messablauf gegebenenfalls modifiziert, die Berechnung für den modifizierten Messablauf erneut durchgeführt, der modifizierte Messablauf gegebenenfalls erneut modifiziert und so weiter, zumindest bis in einem Durchlauf oder Iterationsschritt ein modifizierter Messablauf erzeugt wurde, für den die Berechnung ergibt, dass der jeweilige Grenzwert für die SAR und/oder die Gradientenstimulation voraussichtlich nicht überschritten wird.

Das Modifizieren des jeweiligen Messablaufs, also des vorgegebenen geplanten Messablaufs und/oder des bereits im vorherigen Iterationsschritt modifizierten Messablaufs, kann beispielsweise zufällig erfolgen, also indem eine mögliche Modifikation aus dem abstrakten Raum aller möglichen Modifikationen ausgewählt und angewendet wird. Bevorzugt kann ein Optimierungsverfahren, beispielsweise ein Gradientenabstiegsverfahren oder eine binäre Suche, angewendet werden, um einen entsprechend optimierten modifizierten Messablauf aufzufinden. Besonders bevorzugt können bei dem Berechnen und/oder bei dem Modifizieren Teilergebnisse des Berechnens oder Simulierens eines Messablaufs in nachfolgenden Iterationsschritten berücksichtigt, insbesondere wiederverwendet werden. Wurde beispielsweise in einem Iterationsschritt für eine bestimmte Sequenz oder für einen Teil oder Teilabschnitt einer bestimmten Sequenz des jeweiligen Messablaufs die resultierende SAR und/oder Gradientenstimulation berechnet, diese Sequenz dann für den nächsten Iterationsschritt jedoch nicht modifiziert, so können die für diese Sequenz beziehungsweise für diesen Teil oder Teilabschnitt der jeweiligen Sequenz berechneten SAR- und/oder Gradientenstimulationswerte bei der entsprechenden Berechnung oder Simulation des modifizierten Messablaufs für den nächsten Iterationsschritt übernommen werden. Weiterhin kann ein jeweiliger Verlauf der Gradientenstimulation- und/oder der SAR ganz oder teilweise vorberechnet und anschließend lediglich mit oder in Abhängigkeit von patientenspezifischen Parametern modifiziert werden, beispielsweise durch Skalierung eines mit einem für das Vorberechnen verwendeten, vorgegebenen Standard-Körpergewicht berechneten SAR-Verlaufs mit einem jeweiligen tatsächlichen Patientengewicht. Hierdurch kann vorteilhaft Rechenzeit und Rechenaufwand eingespart werden.

In einem weiteren Verfahrensschritt des erfindungsgemäßen Verfahrens wird wenigstens der aktuelle modifizierte Messablauf, der also gemäß der Berechnung voraussichtlich nicht zum Überschreiten des jeweiligen vorgegebenen Grenzwertes führt und der die wenigstens eine vorgegebene Randbedingung erfüllt, ausgegeben. Dieses Ausgeben kann ein Ausgeben an den jeweiligen Benutzer oder Anwender bedeuten oder umfassen. Zusätzlich oder alternativ kann das Ausgeben bedeuten, dass der automatisch erzeugte aktuelle modifizierte Messablauf von der Berechnungseinrichtung an eine weitere Einrichtung, beispielsweise ein Steuergerät, der MRT-Anlage ausgegeben, also übermittelt oder übertragen wird.

Erfindungsgemäß werden mehrere modifizierte Messabläufe bestimmt, die jeweils voraussichtlich, also gemäß der Berechnung, nicht zum Überschreiten des jeweiligen Grenzwertes, also der Grenzwerte für die SAR und/oder die Gradientenstimulation, führen. In Abhängigkeit von der wenigstens einen vorgegebenen Randbedingung wird dann einer der bestimmten modifizierten Messabläufe automatisch zur Verwendung ausgewählt. Es wird dabei derjenige der mehreren bestimmten modifizierten Messabläufe zur Verwendung ausgewählt, der den höchsten Erfüllungsgrad beziehungsweise Übererfüllungsgrad bezüglich der, also für die, wenigstens eine vorgegebene Randbedingung aufweist. Ist beispielsweise als Randbedingung ein minimal zu erreichender Kontrastwert vorgegeben, so kann derjenige Messablauf ausgewählt werden, der den höchsten Kontrastwert aufweist. Damit können mehrere Vorteile kombiniert werden.

Beispielsweise kann durch das Bestimmen mehrerer gültiger modifizierte Messabläufe mit höherer Wahrscheinlichkeit ein optimaler oder optimalerer modifizierter Messablauf aufgefunden werden und gleichzeitig kann ein besonders hoher Automatisierungsgrad des Verfahrens erreicht beziehungsweise aufrechterhalten werden, da zum Auswählen des tatsächlich zu verwendenden modifizierten Messablaufs keine zusätzliche Benutzerinteraktion notwendig ist. Dadurch dass das automatische Auswählen in Abhängigkeit von der vorgegebenen Randbedingung erfolgt, kann dabei zudem sichergestellt werden, dass der letztlich zur Verwendung ausgewählte Messablauf in Einklang mit den Benutzerwünschen, also den jeweiligen fallspezifischen Anforderungen steht.

Mittels des erfindungsgemäßen Verfahrens kann vorteilhaft also eine Grenzwertüberschreitung eines vorgegebenen geplanten Messablaufs automatisch gehandhabt, also ein entsprechender Konflikt gelöst und automatisch ein optimierter alternativer modifizierter Messablauf ermittelt oder bestimmt werden, der die Grenzwertüberschreitung vermeidet und gleichzeitig durch Berücksichtigung und Einhaltung der wenigstens einen vorgegebenen Randbedingung für den jeweiligen individuellen Anwendungsfall tatsächlich nutzbringend anwendbar oder verwendbar ist. Durch die Einbeziehung von gegebenem Vorwissen über die jeweilige geplante MRT-Untersuchung, also des gesamten vorgegebenen geplanten Messablaufs, die wenigstens eine vorgegebene Randbedingung und gegebenenfalls weiterer Daten, beispielsweise zu individuellen Eigenschaften des jeweiligen Patienten, können so entsprechende Konflikte besonders schnell und effizient automatisch und mit besonders geringen Einschränkungen oder Einbußen hinsichtlich der Bildqualität und/oder der Messzeit aufgelöst werden.

Das automatisierte Erzeugen und simulieren des beziehungsweise der modifizierten Messabläufe hat zudem den Vorteil, dass der Automatisierungsgrad der gesamten MRT-Untersuchung, also die fachgerechte Benutzung oder Anwendung der MRT-Anlage, erhöht werden kann. Dadurch können vorteilhaft beispielsweise eine für die MRT-Untersuchung insgesamt benötigte Zeit sowie eine Wahrscheinlichkeit für Bedien- oder Anwendungsfehler reduziert werden.

Dem erfindungsgemäßen Verfahren liegen dabei die Idee und die Erkenntnis zugrunde, dass es oftmals nur wenige Randbedingungen gibt, die tatsächlich erfüllt oder eingehalten werden müssen, um letztlich ein sinnvolles und nützliches Messergebnis erhalten zu können oder sicherzustellen. Eine Vielzahl weiterer Parameterwerte, Einflussfaktoren, Einstellmöglichkeiten, etc. kann hingegen modifiziert oder variiert werden, ohne dass dies zu einem im jeweiligen individuellen Anwendungsfall nutz- oder wertlosen Ergebnis führen würde. Diese Vielzahl von Parametern, Parameterwerten, Einstellungen, etc. ist jedoch bei heutzutage verfügbaren MRT-Anlagen und - Anwendungen im Falle einer entsprechenden Grenzwertüberschreitung weder manuell noch automatisch so einstellbar oder anpassbar, dass eine Unterschreitung des jeweiligen Grenzwertes sichergestellt ist. Die Möglichkeiten des Anwenders sind also durch die statischen vorgegebenen Messabläufe oder vorgefertigten hinterlegten Protokolle limitiert. Die vorliegende Erfindung stellt somit durch das automatisierte modifizieren des geplanten Messablaufs durch automatisiertes Anpassen von Protokollparametern, einem Sequenzablauf und/oder dergleichen eine Lösung bereit, die praktikabel realisierbar ist, beispielsweise im Gegensatz zu dem Ansatz, sämtliche Variationsmöglichkeiten, also sämtliche möglichen modifizierten Messabläufe dem Benutzer in vorgefertigter Form zur Auswahl bereitzustellen.

In vorteilhafter Ausgestaltung der vorliegenden Erfindung wird als die mindestens eine Randbedingung ein minimal abzubildendes Volumen des Untersuchungsobjekts, also eine minimale Schichtabdeckung, und/oder eine minimale Auflösung, mit der das Untersuchungsobjekt abzubilden ist, und/oder eine maximale Messzeit für den Messablauf insgesamt und/oder ein Zeitpunkt einer Kontrastmitteleinbringung in das Untersuchungsobjekt und/oder eine einzuhaltende Echozeit und/oder Repetitionszeit vorgegeben. Durch Vorgeben des minimal abzubildenden Volumens kann vorteilhaft sichergestellt werden, dass alle für eine zuverlässige Diagnose des Patienten oder eine Bewertung des Zustands des Untersuchungsobjekts notwendigen Bereiche tatsächlich abgebildet werden, was bei der herkömmlicherweise verfügbaren Option zur Reduzierung der Anzahl der abgebildeten Schichten nicht immer der Fall ist. Durch das Vorgeben einer maximalen Messzeit kann vorteilhaft zum einen ermöglicht werden, dass die für die MRT-Untersuchung zur Verfügung stehende Zeit maximal ausgenutzt werden kann, was zu einer insgesamt verbesserten Bildqualität führen kann. Zum anderen kann vorteilhaft sichergestellt werden, dass die MRT-Untersuchung tatsächlich in der zur Verfügung stehenden Zeit vollständig abgeschlossen ist, sodass eine effiziente Nutzung und optimale Auslastung der MRT-Anlage ermöglicht wird. So kann beispielsweise sichergestellt werden, dass nachfolgende Untersuchungen weiterer Untersuchungsobjekte oder Patienten mittels der MRT-Anlage wie geplant durchgeführt werden können, also nicht verschoben werden müssen. Durch das Vorgeben des Zeitpunktes der Kontrastmitteleinbringung kann vorteilhaft sichergestellt werden, dass der automatisch erzeugte modifizierte Messablauf verträglich ist mit externen organisatorischen Schritten und Abläufen, dass eine unnötige Wartezeit oder Pause während der MRT-Untersuchung vermieden wird und dass während einer hinsichtlich der Bildqualität relevanten Verweildauer des Kontrastmittels in dem Untersuchungsobjekt beispielsweise eine maximale verträgliche Leistung der MRT-Anlage angewendet werden kann. Es kann also beispielsweise der Fall vermieden werden, dass nach dem Einbringen des Kontrastmittels eine Abkühlungsphase notwendig ist, während derer eine Ausbreitung des Kontrastmittels dann nicht oder nicht mit optimaler Bildqualität abgebildet werden kann. Durch das Vorgeben der einzuhaltenden definierten Echozeit kann vorteilhaft sichergestellt werden, dass beispielsweise bei Verwendung eines BOLD-verfahrens (englisch: "Blood Oxigenation Level Dependant") eine standardisierte Auswertung der Messergebnisse angewendet werden kann und eine Vergleichbarkeit der Messergebnisse gegeben ist beziehungsweise gegeben bleibt. Durch Vorgeben einer definierten Kombination aus einzuhaltender Echozeit und einzuhaltender Repetitionszeit kann vorteilhaft sichergestellt werden, dass ein gewünschter Signalkontrast erzielt werden kann, also tatsächlich erreicht wird, um eine optimale Befundung der Untersuchungsergebnisse zu ermöglichen.

In vorteilhafter Ausgestaltung der vorliegenden Erfindung wird zum oder beim Modifizieren des jeweiligen, mehrere nacheinander auszuführende Sequenzen umfassenden Messablaufs eine Sequenzreihenfolge geändert und/oder wenigstens eine Sequenz des jeweiligen Messablaufs gegen eine in einer Datenbank hinterlegte Alternativsequenz ausgetauscht, wobei die Alternativsequenz in wenigstens einer Wirkung der ersetzten Sequenz entspricht. Mit anderen Worten kann also eine Reihenfolge variiert werden, in der die einzelnen Sequenzen des jeweiligen Messablaufs durchgeführt werden, wobei vollständige Sequenzen umsortiert und/oder Sequenzen in mehreren Verknüpfungen (englisch "concats") miteinander verschachtelt werden können. Dies kann etwa dann vorteilhaft sein, falls es nur in einem Teilabschnitt des Messablaufs zur Überschreitung des jeweiligen Grenzwertes kommt, insbesondere wenn der betroffene Teilabschnitt kürzer ist als eine Sequenz. Besonders vorteilhaft ist dabei, dass das Überschreiten des jeweiligen Grenzwerts gegebenenfalls ohne Einbuße der Bildqualität und ohne Verlängerung der Messzeit vermieden werden kann.

Das Austauschen einer oder mehrerer Sequenzen gegen eine jeweilige in der wenigstens einen Wirkung oder Hinsicht gleichwertige oder gleichwirkende Alternativsequenz bedeutet, dass beispielsweise die ersetzte Sequenz und die Alternativsequenz die gleichen Kontrastwerte liefern, die gleiche Messzeit beanspruchen, die gleiche Robustheit gegenüber Bewegungen des Untersuchungsobjekts aufweisen und/oder dergleichen mehr, wobei sich die ersetzte Sequenz und die Alternativsequenz jedoch in anderer Hinsicht oder in anderer Wirkung, letztlich also in wenigstens einer anderen Eigenschaft, unterscheiden. So kann eine für den jeweiligen Anwendungsfall besonders vorteilhafte oder besonders wichtige Größe, wie etwa der erzielte Kontrast oder die benötigte Messzeit konstant gehalten werden und dazu eine Einschränkung oder ein Nachteil in Kauf genommen werden, die beziehungsweise der für die jeweilige individuelle MRT-Untersuchung nicht oder zumindest weniger relevant oder wichtig sind.

Da hierbei vorgefertigte Sequenzen und/oder Messparametrisierungen, also vorgegebene Parametrisierungen eines Messablaufes, verwendet werden können, kann so insgesamt mit besonders geringem Aufwand eine Optimierung des Messablaufs erreicht werden. Auch kann die Berechnung gegebenenfalls besonders schnell durchgeführt werden, da für die bekannten vorgefertigten Sequenzen die jeweilige voraussichtlich auftretende SAR und/oder Gradientenstimulation beziehungsweise der jeweilige Beitrag der Sequenz hierzu ebenfalls in der Datenbank der jeweiligen Sequenz zugeordnet hinterlegt sein kann. Ein Beispiel für das Ändern der Sequenzreihenfolge kann beispielsweise sein in dem Messablauf die Sequenzabfolge TSE koronar, EPI transversal, TSE transversal zu verwenden anstelle der Sequenzabfolge TSE koronar, TSE transversal, EPI transversal. Zum Verschachtelten zweier oder mehrerer Sequenzen können diese in mehrere Teile oder Teilsequenzen zerlegt oder aufgeteilt werden. Es können dann abwechselnd Teilsequenzen unterschiedlicher Sequenzen ausgeführt werden. Als Beispiel für einen Austausch einer Sequenz gegen eine gleichwertige oder gleichwirkende Alternativsequenz kann zum Beispiel eine HASTE-Sequenz mit langer Repetitionszeit TR gegen eine SMS-TSE-Sequenz ausgetauscht werden. Dabei stehen TSE für "Turbo Spin Echo", EPI für "Echo Planar Imaging", HASTE für "Half Fourier-Acquired Single shot Turbo spin Echo" und SMS für "Simultaneous Multislice".

In vorteilhafter Weiterbildung der vorliegenden Erfindung wird die Alternativsequenz automatisch ausgewählt in Abhängigkeit von der wenigstens einen vorgegebenen Randbedingung, die die Wirkung, in der sich die ersetzte Sequenz und die Alternativsequenz entsprechen sollen, bestimmt. Mit anderen Worten wird also durch die Randbedingung vorgegeben oder aus der Randbedingung abgeleitet, welche Wirkung oder Eigenschaft der jeweiligen Sequenz oder Sequenzen für den vorliegenden Anwendungsfall als besonders wichtig oder relevant einzustufen sind. Da im vorliegenden Verfahren die Randbedingung ohnehin vorgegeben wird, kann so vorteilhaft ohne weitere Benutzereingabe besonders zuverlässig eine Alternativsequenz automatisch bestimmt und ausgewählt werden, die abgestimmt auf die jeweilige individuelle Anwendung zu einer möglichst geringen oder möglichst wenig ausschlaggebenden Einschränkung führt. Ist beispielsweise als Randbedingung eine einzuhaltende bestimmte oder maximale Messzeit für den gesamten Messablauf vorgegeben, so können vorteilhaft automatisch nur solche Alternativsequenzen ausgewählt und verwendet werden, deren Messzeit höchstens derjenigen der ersetzten Sequenz entspricht. Somit können durch das Auswählen der Alternativsequenz in Abhängigkeit von der vorgegebenen Randbedingung also die Anzahl infrage kommender Alternativsequenzen reduziert und damit auch die für das iterative Verfahren insgesamt benötigte Zeit - zumindest im Durchschnitt - verringert werden.

In vorteilhafter Ausgestaltung der vorliegenden Erfindung wird zum Modifizieren des jeweiligen Messablaufs automatisch eine Charakteristik eines oder mehrerer Pulse des Messablaufs modifiziert, insbesondere hinsichtlich eines Pulstyps und/oder einer Pulsdauer und/oder einer Pulsamplitude. Mit anderen Worten kann also wenigstens ein einzelner von der MRT-Anlage für die Untersuchung zu erzeugender elektromagnetischer Puls in zumindest einer Eigenschaft modifiziert, also verändert oder angepasst werden. Durch die Möglichkeit, einen oder mehrere einzelne Pulse individuell zu modifizieren, kann der Messablauf vorteilhaft besonders feinkörnig modifiziert werden, also mit höherer Granularität als sie beispielsweise das Austauschen ganzer Sequenzen bietet. Somit kann durch das Modifizieren des oder der einzelne Pulse beispielsweise der jeweilige Grenzwert für die SAR und/oder für die Gradientenstimulation möglichst vollständig ausgeschöpft werden, wodurch eine besonders hohe Bildqualität und/oder eine besonders kurze Messzeit erreicht werden kann.

Wird beispielsweise der jeweilige Grenzwert nur minimal überschritten, insbesondere nur zu einem einzigen Zeitpunkt während des gesamten Messablaufs, so würde die herkömmlich verfügbare Option zur signifikanten Reduktion der Anzahl der abgebildeten Schichten eine unnötig starke Einschränkung bedeuten, bei deren Verwendung der jeweilige Grenzwert bei weitem unterschritten würde. Demgegenüber kann beispielsweise durch Erhöhen der Dauer und Reduzieren der Amplitude eines einzelnen Pulses unmittelbar vor dem Zeitpunkt, zu dem die Grenzwertüberschreitung in dem geplanten Messablauf auftritt, mit vergleichsweise geringerer Verschlechterung der Bildqualität die Grenzwertüberschreitung vermieden werden.

Besonders vorteilhaft können beispielsweise in einer entsprechenden der Berechnungseinrichtung zugänglichen Datenbank verschiedene Pulstypen gemeinsam mit einer jeweiligen zugeordneten Patientenbelastung oder einen jeweiligen zugeordneten SAR-Wert hinterlegt sein. Unter Zugriff auf diese Datenbank kann dann beispielsweise der Pulstyp in Richtung geringerer SAR-Werte modifiziert oder variiert werden, bis die jeweilige Berechnung keine Überschreitung, also ein Unterschreiten des jeweiligen Grenzwertes ergibt. Wie beim Austausch ganzer Sequenzen kann also beispielsweise ein einzelner Puls gegen einen Alternativpuls, insbesondere einen Low SAR-Puls, der also zu einem geringeren SAR-Wert führt, ausgetauscht werden. Dabei kann vorteilhaft die Anzahl verschiedener Pulse oder Pulstypen und/oder ein jeweiliger Zusammenhang zwischen Pulsdauer und/oder Pulsamplitude und resultierendem SAR-Wert praktikabel, also mit signifikant geringerem Aufwand im Vorhinein bestimmt und in einer entsprechenden Datenbank hinterlegt sein als beispielsweise sämtliche möglichen Kombinationen und Abfolgen einer Vielzahl von einzelnen Pulsen, wie sie in einem Messablauf typischerweise verwendet werden. Dementsprechend kann auch hier Berechnungszeit und Berechnungsaufwand für das Berechnen der voraussichtlich auftretenden SAR eingespart werden.

In vorteilhafter Ausgestaltung der vorliegenden Erfindung werden zum Modifizieren des jeweiligen Messablaufs aufeinander abgestimmt eine Anzahl von abgebildeten Schichten reduziert, eine Schichtdicke der abgebildeten Schichten erhöht, eine Anzahl von Phasenkodierschritten reduziert und eine Basisauflösung reduziert. Durch diese Kombination von Modifikationen oder Maßnahmen kann vorteilhaft erreicht werden, dass sich in allen drei Raumrichtungen oder Dimensionen eine gleichmäßige Auflösungsreduktion ergibt. Mit anderen Worten kann so trotz der verschlechterten Bildqualität diese konsistent gehalten werden. Dadurch kann eine Erkennbarkeit oder Interpretierbarkeit der Messergebnisse der MRT-Untersuchung, also der resultierenden Bilder oder Bilddaten verbessert werden. Das jeweilige tatsächliche Ausmaß, in dem die genannten Parameter oder Parameterwerte angepasst, also reduziert beziehungsweise erhöht werden, kann vom jeweiligen Einzelfall abhängen, jedoch in jedem Fall in Abhängigkeit voneinander erfolgen. Dazu kann beispielsweise ein entsprechendes mehrdimensionales Kennfeld oder eine Wertetabelle hinterlegt sein, woraus entsprechend aufeinander abgestimmte Werte oder Veränderungen beziehungsweise Verstellumfänge entnehmbar sind, die zu der gewünschten gleichmäßigen Auflösungsreduktion führen.

In vorteilhafter Ausgestaltung der vorliegenden Erfindung wird zum Modifizieren des jeweiligen Messablaufs ein darin vorgesehener Flipwinkel reduziert. Da für einen geringeren Flipwinkel eine geringere Feldstärke und/oder eine geringere Pulsdauer benötigt wird, kann die Belastung für das Untersuchungsobjekt beziehungsweise den Patienten reduziert werden. Diese Belastungsreduktion durch Reduzieren des Flipwinkels kann dabei vorteilhaft ohne Verlängerung der insgesamt für den Messablauf benötigten Messzeit erreicht werden.

In vorteilhafter Ausgestaltung der vorliegenden Erfindung werden zum Modifizieren des jeweiligen Messablaufs einerseits eine Auslesebandbreite der MRT-Anlage verändert und andererseits darauf abgestimmt ein partieller Fourier-Faktor erhöht oder eine Anzahl von Phasenkodierschritten reduziert. Dies kann beispielsweise vorteilhaft sein, um die Randbedingung einer gleichbleibenden Echozeit (TE) einzuhalten. Eine reduzierte Auslesebandbreite ist zwar verbunden mit einer längeren Auslesezeit, durch den erhöhten partiellen Fourier-Faktor müssen jedoch weniger einzelne Messwerte tatsächlich ausgelesen werden. Dies bedeutet ebenso wie die Reduktion der Anzahl von Phasenkodierschritten eine Zeitersparnis, durch die die verlängerte Auslesezeit aufgrund der reduzierten Auslesebandbreite ausgeglichen werden kann. Durch die Erhöhung des partiellen Fourier-Faktors beziehungsweise eine Aktivierung eines partiellen Fourier-verfahrens kann vorteilhaft der Umstand ausgenutzt werden, dass es im k-Raum stets eine Redundanz gibt, zumindest einige Werte also aus anderen berechnet werden können. Die durch die geringere Anzahl von tatsächlich auszulesenden, also zu messenden Werten, wird die Patientenbelastung reduziert. Dies geht in der Praxis zwar mit einer beispielsweise aufgrund von Magnetfeldinhomogenitäten, Suszeptibilitätseffekten, einer Bewegung des Untersuchungsobjekts, mangelnder Gleichförmigkeit der RF-Übertragung und/oder dergleichen mehr mit einer verringerten Genauigkeit oder Zuverlässigkeit der berechneten, also nicht direkt ausgelesenen oder gemessenen Werte oder Daten einher. Diese Einflussfaktoren oder Fehlerquellen können vorteilhaft jedoch ohne Erhöhung der Patientenbelastung, also der SAR und/oder der Gradientenstimulation, verringert werden, beispielsweise durch Verwendung höherqualitativer Bauteile und/oder einer präziseren Kalibrierung der MRT-Anlage und/oder durch Anwendung eines Kompensationsverfahrens für eine Bildrekonstruktion, beispielsweise mittels eines Homodyne-Algorithmus.

In vorteilhafter Ausgestaltung der vorliegenden Erfindung wird das iterative automatische Modifizieren des jeweiligen Messablaufs anhand einer vorgegebenen Prioritätsliste durchgeführt, in der mit einer jeweiligen Priorität annotierte Modifikationen hinterlegt sind. Dabei werden Modifikationen mit höherer Priorität bevorzugt vorgenommen. Mit anderen Worten wird somit der jeweilige Messablauf nicht beispielsweise zufällig modifiziert, sondern die verschiedenen Modifikationen werden gemäß der Prioritätsliste in Reihenfolge absteigender Priorität durchgeführt oder vorgenommen. Es kann also eine Modifikation aus der Prioritätsliste auf den jeweiligen Messablauf angewendet, der entsprechend modifizierte Messablauf dann simuliert werden und, sofern sich weiterhin eine Überschreitung der Grenzwerte ergibt, zusätzlich oder alternativ die in der Prioritätsliste nächste Modifikation, also die Modifikation mit der nächst geringeren Priorität, auf den geplanten oder modifizierten Messablauf angewendet werden und so weiter. Durch die Prioritätsliste kann also mittels einer, insbesondere einmaligen, Maßnahme - eben dem Vorgeben oder Bereitstellen der Prioritätsliste - eine Vielzahl von Iterationsschritten oder Anwendungsinstanzen des Verfahrens hinsichtlich des Erzeugens modifizierter Messabläufe gesteuert oder beeinflusst werden. Die Prioritätsliste bietet also eine besonders effiziente Möglichkeit zur Optimierung des erfindungsgemäßen Verfahrens.

Eine einzelne Modifikation kann im Sinne der vorliegenden Erfindung eine einzelne Maßnahme, wie beispielsweise eine Veränderung einer Pulsamplitude, oder ein Bündel mehrerer Maßnahmen, die im selben Iterationsschritt auf ein und denselben Messablauf angewendet werden, sein. Besonders vorteilhaft können mehrere Prioritätslisten vorgegeben sein, in denen die einzelnen Modifikationen im Hinblick auf unterschiedliche Wirkungen oder Eigenschaften der resultierenden Bilddaten sortiert sind. Beispielswese können in einer ersten Prioritätsliste die Modifikationen derart sortiert sein, dass Modifikationen mit höherer Priorität eine geringere Kontrastverschlechterung bewirken als Modifikationen mit niedrigerer Priorität. In einer zweiten Prioritätsliste können die Modifikationen dann beispielsweise derart sortiert sein, dass Modifikationen mit höherer Priorität in geringerem Maße oder Umfang zu einer Verlängerung der Gesamtmesszeit des Messverlaufs führen als Modifikationen mit niedrigerer Priorität. Anhand einer oder mehrerer derartiger Prioritätslisten, deren Modifikationen der Reihe nach angewendet und simuliert werden, kann vorteilhaft also zuverlässig eine minimale Verschlechterung gefunden werden, die noch das Überschreiten der Grenzwerte vermeidet.

In vorteilhafter Ausgestaltung der vorliegenden Erfindung wird automatisch wenigstens eine neue Randbedingung abgefragt oder abgerufen, falls nach einer vorgegebenen Anzahl von Iterationen oder Iterationsschritten kein modifizierter Messablauf erzeugt worden ist, der die bisherige, also bis dahin gültige, wenigstens eine vorgegebene Randbedingung erfüllt und nicht zum Überschreiten des jeweiligen Grenzwertes führt. Mit anderen Worten kann also, nachdem die vorgegebene Anzahl von Iterationen, also von Berechnungs- und Erzeugungs- oder Modifikationsschritten, erfolglos durchgeführt worden ist, eine Anfrage an den jeweiligen Benutzer ausgegeben werden, mit der dieser zur Eingabe oder Vorgabe wenigstens einer modifizierten oder neuen Randbedingung aufgefordert wird. Ebenso kann das Abfragen der neuen Randbedingung beispielsweise bedeuten, dass eine modifizierte oder neue Randbedingung aus einer bereitgestellten Datenbank oder Liste abgerufen und verwendet wird.

Das Abfragen der neuen Randbedingung kann jeweils wiederholt werden, sobald erneut wenigstens die vorgegebene Anzahl von Iterationen erfolglos durchlaufen worden ist, also ohne dass ein gültiger modifizierter Messablauf gefunden, also erzeugt worden ist, der die jeweils verwendete aktuelle Randbedingung erfüllt und nicht zum Überschreiten des jeweiligen Grenzwertes oder der jeweiligen Grenzwerte führt. Auf diese Weise kann vorteilhaft eine für das Verfahren, also das Auffinden eines entsprechenden gültigen modifizierten Messablaufs, benötigte Zeit begrenzt oder zumindest dem jeweiligen Benutzer nach einer begrenzten Zeit jeweils zuverlässig und konsistent eine Möglichkeit zum Eingriff in das iterative Verfahren gegeben werden. Somit kann das erfindungsgemäße Verfahren vorteilhaft auch dann problemlos angewendet werden, falls die Berechnungseinrichtung nicht ausreichend Rechenkapazität aufweist und/oder falls nicht genug Zeit zur Verfügung steht, um den gesamten möglichen Parameter- oder Modifikationsraum, also den abstrakten Raum aller möglichen Kombinationen aller möglichen Modifikationen, zu durchlaufen oder zu simulieren. Insbesondere kann so also die Problematik vermieden werden, dass die Berechnungseinrichtung und damit die MRT-Anlage dauerhaft ausgelastet wird und nicht für eine tatsächliche Untersuchung verwendet werden kann.

In vorteilhafter Ausgestaltung der vorliegenden Erfindung werden mehrere Randbedingungen vorgegeben. Weiterhin werden dann mehrere modifizierte Messabläufe bestimmt, die jeweils gemäß der jeweiligen Berechnung voraussichtlich nicht zum Überschreiten des jeweiligen vorgegebenen Grenzwertes führen. Die mehreren bestimmten modifizierten Messabläufe werden dann in Abhängigkeit von einer Gewichtung der Randbedingungen sortiert. Mit anderen Worten werden also mehrere mögliche gültige modifizierte Messabläufe bestimmt, die hinsichtlich der vorgegebenen Grenzwerte zulässig sind und zumindest eine, bevorzugt alle der mehreren Randbedingungen erfüllen oder einhalten. Über die jeweilige Gewichtung und Sortierung wird dann bestimmt oder angegeben, in welchem Maße oder zu welchem Grad die bestimmten modifizierten Messabläufe die vorgegebenen Randbedingungen erfüllen beziehungsweise übererfüllen. So können beispielsweise zwei unterschiedliche modifizierte Messabläufe bestimmt werden, die beide sowohl die vorgegebenen Grenzwerte als auch die vorgegebenen Randbedingungen einhalten oder erfüllen. Der erste dieser beiden bestimmten modifizierten Messabläufe kann dabei aber beispielsweise eine längere Messzeit und einen höheren Kontrast aufweisen als der zweite der beiden bestimmten modifizierten Messabläufe. Als Randbedingungen können beispielsweise eine bestimmte maximale Messzeit und ein bestimmter minimaler Kontrastwert vorgegeben sein. Die beiden bestimmten modifizierten Messabläufe weisen dann hinsichtlich der beiden Randbedingungen unterschiedliche Übererfüllungsgrade auf. Je nachdem, welche der beiden Randbedingungen höher gewichtet ist, würde dann der erste oder der zweite der beiden bestimmten modifizierten Messabläufe höher einsortiert oder bewertet werden.

Die sortierten bestimmten modifizierten Messabläufe können etwa in Form einer Liste an den Benutzer oder Anwender ausgegeben werden. Diesem wird somit vorteilhaft die Möglichkeit geboten, aus mehreren möglichen gültigen modifizierten Messabläufe denjenigen zur Verwendung auszuwählen, der im Einzelfall den jeweiligen Bedürfnissen oder Anforderungen oder Vorlieben besser entspricht. Die bestimmten modifizierten Messabläufe können dem Benutzer also als Vorschläge ausgegeben werden. Ebenso kann beispielsweise der unter Berücksichtigung der Gewichtung am höchsten einsortierte oder bewertete Messablauf automatisch zur Verwendung ausgewählt werden. Die Gewichtung oder Gewichtungen für die Randbedingungen kann beziehungsweise können von dem Benutzer vorgegeben oder ausgewählt oder automatisch bestimmt oder festgelegt werden.

Ebenso kann es beispielsweise möglich sein, dass mehrere modifizierte Messabläufe bestimmt werden, die zwar jeweils eine aber nicht alle Randbedingungen erfüllen und somit je nach Gewichtung der einzelnen Randbedingungen bezüglich eines Erfüllungsgrades der Gesamtheit aller Randbedingungen eine unterschiedliche Reihenfolge oder Rangfolge aufweisen.

Um mehrere entsprechend gültige modifizierte Messabläufe zu bestimmen, kann ein bestimmter gültiger modifizierter Messablauf zwischengespeichert werden, sobald er bestimmt wurde, und das Verfahren dann mit dem nächsten Iterationsschritt, also beispielsweise einer weiteren Modifikation, fortgeführt werden. Dabei kann der bestimmte gültige modifizierte Messablauf weiter modifiziert werden oder es kann beispielsweise ein zuvor bestimmter, ungültiger Messablauf als neuer Ausgangspunkt verwendet und modifiziert werden. Ein ungültiger Messablauf ist dabei ein Messablauf, der zum Überschreiten der Grenzwerte führt und/oder die vorgegebenen Randbedingungen nicht erfüllt. Das Verfahren kann so lange fortgeführt werden, bis eine vorgegebene Anzahl von gültigen Messabläufe bestimmt worden ist, eine vorgegebene Anzahl von Iterationsschritten durchlaufen wurde und/oder eine vorgegebene Zeit abgelaufen ist, also für das erfindungsgemäße Verfahren aufgewendet wurde. Durch das Bestimmen mehrerer gültiger modifizierte Messabläufe kann vorteilhaft mit größerer Zuverlässigkeit oder Wahrscheinlichkeit ein optimaler Messablauf oder zumindest ein mehr an dem Optimum liegender Messablauf aufgefunden werden. Ebenso können vorteilhaft, insbesondere auch ohne entsprechend komplexe Eingabemaske, jeweilige Benutzerwünsche, vorliegenden oder Anforderungen besser berücksichtigt und erfüllt werden.

Die beschriebenen Modifikationen, also die Maßnahmen zum Modifizieren des jeweiligen Messablaufs, können nicht nur in den hier explizit beschriebenen Kombinationen, sondern ebenso in anderen Kombinationen oder einzeln verwendet oder angewendet werden.

Ein weiterer Aspekt der vorliegenden Erfindung ist eine MRT-Anlage mit einer Eingangsschnittstelle zum Erfassen wenigstens einer vorgegebenen Randbedingung, mit einer Ausgabeschnittstelle und mit einer mit der Eingangsschnittstelle und mit der Ausgangsschnittstelle durch eine jeweilige Datenverbindung verbundenen Berechnungseinrichtung. Die Berechnungseinrichtung umfasst dabei einen Datenspeicher mit einem Programmcode, der mindestens eine Ausführungsform des erfindungsgemäßen Verfahrens zum Betreiben der MRT-Anlage kodiert oder repräsentiert. Die Berechnungseinrichtung der erfindungsgemäßen MRT-Anlage umfasst weiterhin eine mit dem Datenspeicher gekoppelte Prozessoreinrichtung zum Ausführen des Programmcodes. Mit anderen Worten ist also die erfindungsgemäße MRT-Anlage zum Ausführen oder Durchführen des erfindungsgemäßen Verfahrens, also für einen Betrieb gemäß dem erfindungsgemäßen Verfahren eingerichtet. Dementsprechend können die erfindungsgemäße MRT-Anlage insbesondere die im Zusammenhang mit dem erfindungsgemäßen Verfahren genannte MRT-Anlage und die Berechnungseinrichtung der erfindungsgemäßen MRT-Anlage insbesondere die im Zusammenhang mit dem erfindungsgemäßen Verfahren genannte Berechnungseinrichtung sein. Die Ausgabeschnittstelle der erfindungsgemäßen MRT-Anlage ist dementsprechend eingerichtet zum automatischen Ausgeben wenigstens desjenigen aktuellen modifizierten Messablaufs der mehreren modifizierten Messabläufe, die gemäß der jeweiligen Berechnung voraussichtlich nicht zum Überschreiten des jeweiligen vorgegebenen Grenzwertes für die SAR und/oder die Gradientenstimulation führen und der den höchsten Erfüllungsgrad oder Übererfüllungsgrad bezüglich der wenigstens einen vorgegebenen Randbedingung aufweist.

Die bisher und im Folgenden angegebenen Eigenschaften und Weiterbildungen des erfindungsgemäßen Verfahrens sowie die entsprechenden Vorteile sind jeweils sinngemäß auf die erfindungsgemäße MRT-Anlage und/oder zur Durchführung des erfindungsgemäßen Verfahrens verwendete oder verwendbare Bauteile und Einrichtungen übertragbar und umgekehrt. Es gehören also zu der Erfindung auch solche Weiterbildungen des erfindungsgemäßen Verfahrens und der erfindungsgemäßen MRT-Anlage, welche Ausgestaltungen aufweisen, die hier zur Vermeidung unnötiger Redundanz nicht explizit in der jeweiligen Kombination beschrieben sind.

Weitere Merkmale, Einzelheiten und Vorteile der vorliegenden Erfindung ergeben sich aus der nachfolgenden Beschreibung bevorzugter Ausführungsbeispiele sowie anhand der Zeichnungen. Dabei zeigen:
- FIG 1: eine schematische Seitenansicht einer MRT-Anlage; und
- FIG 2: einen beispielhaften schematischen Ablaufplan eines Verfahrens zum Betreiben der in FIG 1 dargestellten MRT-Anlage.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

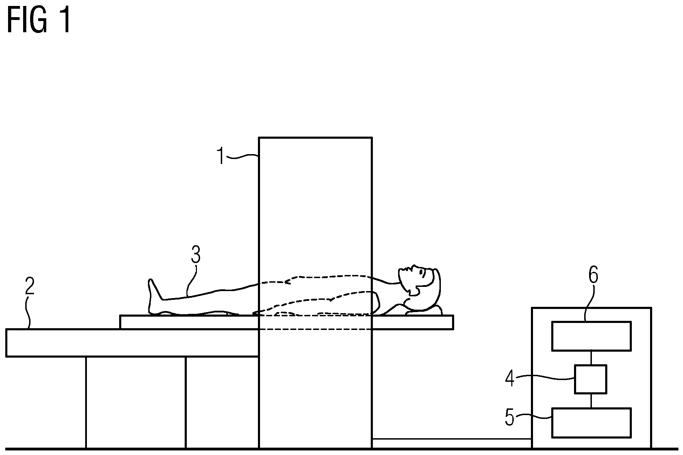

FIG 1 zeigt eine schematische Seitenansicht einer MRT-Anlage 1. Die MRT-Anlage 1 umfasst einen Patiententisch 2, auf dem sich vorliegend als Untersuchungsobjekt ein Patient 3 befindet. Weiterhin umfasst die MRT-Anlage 1 eine Berechnungseinrichtung 4, eine Eingangsschnittstelle 5 und eine Ausgangsschnittstelle, welche vorliegend als Anzeige 6 ausgebildet ist. Die Eingangsschnittstelle 5 und die Anzeige 6 sind mit der Berechnungseinrichtung 4 über eine jeweilige Datenverbindung verbunden. Vorliegend sind die Berechnungseinrichtung 4, die Eingangsschnittstelle 5 und die Anzeige 6 in einem Gehäuseteil der MRT-Anlage angeordnet, der über eine entsprechende Datenverbindung mit hier nicht im Detail näher dargestellten Magneteinrichtungen der MRT-Anlage 1 zu deren Steuerung verbunden ist. Das bedeutet, dass die Berechnungseinrichtung 4 beispielsweise berechnete Ergebnisse, daraus abgeleitete oder erzeugte Steuersignale und/oder über die Eingangsschnittstelle 5 empfangene Benutzereingaben zur Steuerung der MRT-Anlage 1 an die entsprechenden Steuergeräte beziehungsweise Einrichtungen, also beispielsweise an einen Verstärker oder Pulsgenerator, eine Gradientenspule oder dergleichen, übermitteln kann, um eine Untersuchung oder Abbildung des Patienten 3 mittels der MRT-Anlage 1 zu steuern oder zu beeinflussen.

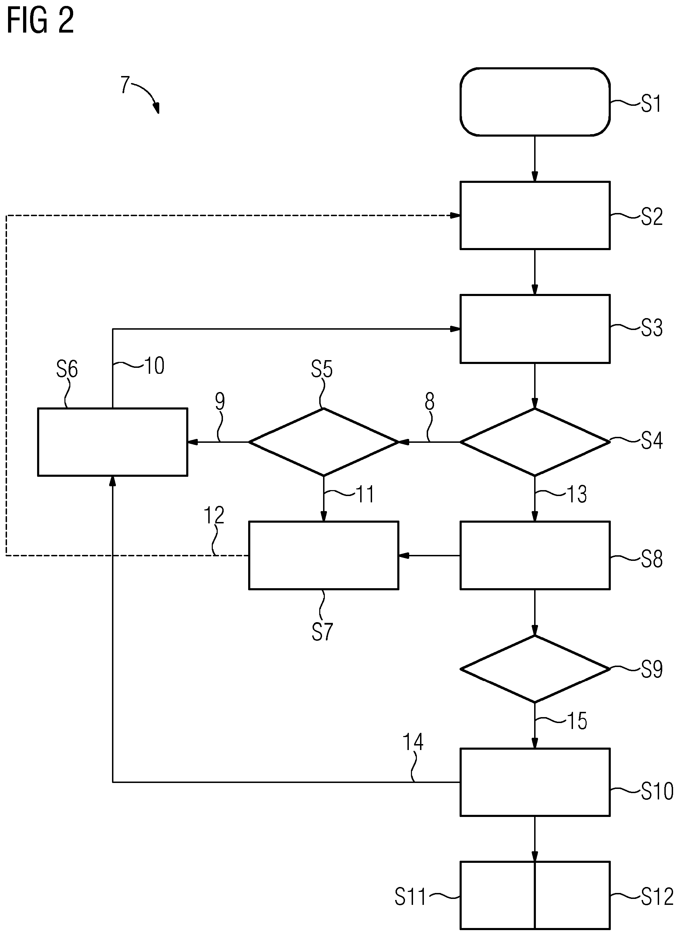

FIG 2 zeigt einen beispielhaften schematischen Ablaufplan 7 eines Verfahrens zum Betreiben der in FIG 1 dargestellten MRT-Anlage 1. Der Ablaufplan 7 beziehungsweise das entsprechende Verfahren wird unter Bezugnahme auf FIG 1 und FIG 2 erläutert.

Das Verfahren beginnt mit einem Verfahrensschritt S1. Im Verfahrensschritt S1 wird von einem Anwender über die Eingangsschnittstelle 5 ein geplanter Messablauf für die Untersuchung des Patienten 3 vorgegeben.

In einem Verfahrensschritt S2 werden von dem Benutzer ebenfalls über die Eingangsschnittstelle 5 mehrere Randbedingungen vorgegeben, die bei der Untersuchung des Patienten 3 beziehungsweise von daraus resultierenden Messergebnissen, insbesondere Bildern oder Bilddaten, eingehalten oder erfüllt werden sollen oder müssen. Als Randbedingungen können beispielsweise eine minimale räumliche Auflösung und eine bestimmte, gleichbleibende Messzeit vorgegeben werden. Der Verfahrensschritt S2, also das Vorgeben der Randbedingungen, kann ebenso an anderer Stelle erfolgen, beispielsweise nach dem Verfahrensschritt S4.

In einem Verfahrensschritt S3 wird der vorgegebene geplante Messablauf hinsichtlich einer bei dessen Verwendung für den Patienten 3 zu erwartenden spezifischen Absorptionsrate (SAR) und Gradientenstimulation simuliert. Das heißt, im Verfahrensschritt S3 werden für den vorgegebenen geplanten Messablauf entsprechende Werte für die SAR und die Gradientenstimulation vorausberechnet.

In einem Verfahrensschritt S4 wird durch einen entsprechenden Vergleich mit vorgegebenen Grenzwerten für die SAR und die Gradientenstimulation überprüft, ob die für den vorgegebenen Messablauf berechneten entsprechenden SAR- und Gradientenstimulationswerte die Grenzwerte überschreiten, also übersteigen. Ist dies der Fall, so folgt das Verfahren einem Pfad 8. Beispielsweise weisen Spin-Echo Sequenzen aufgrund darin verwendeter Refokusierungspulse eine höhere SAR auf als Gradientenecho-Sequenzen. Sequenzen mit Inversions- oder Sättigungspulsen weisen eine höhere SAR auf als Sequenzen ohne diesen Pulstyp oder diese Pulsart. Sequenzen mit bipolaren Gradienten, wie beispielsweise EPI oder Fast DIXON, und relativ schnellem Timing weisen oftmals eine relativ hohe Slew Rate auf, können also zu einer relativ hohen Gradientenstimulation führen.

Dem Pfad 8 folgend wird dann in einem Verfahrensschritts S5 überprüft, ob bereits eine vorgegebene Anzahl von Simulationen unterschiedlicher Messabläufe durchgeführt worden ist und/oder ein Möglichkeitsraum aller möglichen Modifikationen des Messablaufs bereits vollständig durch jeweilige Simulationen durchlaufen worden ist. Ist dies nicht der Fall, so folgt das Verfahren einem Pfad 9.

Dem Pfad 9 folgend wird in einem Verfahrensschritt S6 dann der Messablauf automatisch modifiziert und somit automatisch ein modifizierter Messablauf erzeugt. Einer Überschreitung des SAR-Grenzwertes kann beispielsweise durch eine Verringerung einer Pulsamplitude begegnet werden. Dies ist etwa möglich durch eine Reduktion eines Flipwinkels, was zu einer Veränderung eines Bildkontrastes führen kann, und/oder durch eine Verlängerung einer jeweiligen Ausspieldauer eines einzelnen Pulses, was eine Gesamtmesszeit verlängern und eine Signalintensität verringern kann. Weiterhin kann eine Verringerung der SAR beispielsweise durch eine Verlängerung eines zeitlichen Abstandes zwischen einzelnen RF-Pulsen (RF: Radiofrequenz) oder -Pulszügen erreicht werden, beispielsweise durch eine Reduktion einer Anzahl von aufgenommenen oder abgebildeten Schichten des Patienten 3. Einer Überschreitung des Grenzwertes für die Slew Rate, also die Gradientenanstiegsrate, beziehungsweise die Gradientenstimulation kann beispielsweise durch eine Vergrößerung eines Sichtfeldes (englisch: "Field of View") oder durch eine Änderung einer Phasenkodierrichtung begegnet werden. Welche Modifikationen jeweils angewendet oder vorgenommen werden oder zulässig sind, hängt von den jeweils gültigen vorgegebenen Randbedingungen ab, die beim Modifizieren berücksichtigt, also durch den jeweiligen modifizierten Messablauf eingehalten werden müssen.

Das Verfahren folgt dann einem Pfad 10 und simuliert den modifizierten Messablauf in einem nächsten Iterationsschritt des Verfahrensschritts S3 und folgt anschließend von dort aus erneut dem Verlauf des Ablaufplans 7.

Ergibt die Abfrage im Verfahrensschritt S5, dass bereits eine vorgegebene Anzahl von Iterationen, also von Simulationen unterschiedlicher modifizierte Messabläufe durchgeführt worden ist und/oder sämtliche Modifikationsmöglichkeiten ausgeschöpft und simuliert oder berechnet worden sind, so folgt das Verfahren einem Pfad 11 zum Verfahrensschritt S7. Im Verfahrensschritt S7 wird wahlweise das Verfahren beendet oder einem Pfad 12 folgend mindestens eine neue Randbedingung abgefragt, entsprechend einer nächsten Iteration des Verfahrensschritts S2. In letzterem Fall wird vom Verfahrensschritt S2 ausgehend der Ablaufplan 7 mit der gegebenenfalls vorgegebenen neuen Randbedingung erneut durchlaufen.

Ergibt der Vergleich im Verfahrensschritt S4 beziehungsweise einer Iteration des Verfahrensschritt S4, dass die Grenzwerte bei Verwendung des zuletzt modifizierten und simulierten Messablaufs eingehalten, also nicht überschritten werden, so folgt das Verfahren einem Pfad 13 zum Verfahrensschritt S8.

Im Verfahrensschritt S8 wird der entsprechende Messablauf als gültiger Messablauf gespeichert.

In einem Verfahrensschritt S9 wird dann abgefragt, ob bereits eine vorgegebene Anzahl von gültigen Messabläufen bestimmt und gespeichert worden ist und/oder eine vorgegebene Anzahl von Simulationen durchgerechnet worden ist und/oder der durch die aktuell gültigen vorgegebenen Randbedingungen begrenzte oder bestimmte Möglichkeitsraum von Modifikationen durchlaufen worden ist. Ist hier das Ergebnis negativ, sind also beispielsweise weniger als die vorgegebene Anzahl von gültigen Messabläufen gespeichert, so folgt das Verfahren einem Pfad 14 zur nächsten Iteration des Verfahrensschritts S6.

Wie bei dem oder den vorherigen Durchläufen des Verfahrensschritts S6 wird erneut unter Berücksichtigung, also Einhaltung der vorgegebenen Randbedingungen ein modifizierter Messablauf erzeugt. Für diesen neuen modifizierten Messablauf wird dann der Ablaufplan 7 ausgehend von der nächsten Iteration des Verfahrensschritts S3 erneut durchlaufen.

Ergibt die Abfrage im Verfahrensschritt S9 ein positives Ergebnis, so folgt das Verfahren einem Pfad 15 zum Verfahrensschritt S10.

Im Verfahrensschritt S10 werden die gültigen Messabläufe gemäß einer oder mehreren unterschiedlichen Gewichtungen der vorgegebenen Randbedingungen sortiert. Es werden also eine oder mehrere Listen aus sortierten gültigen Messabläufe nun erzeugt, die angeben, welcher der gültigen Messabläufe bei welcher Gewichtung oder Priorisierung der vorgegebenen Randbedingungen zu bevorzugen, also zu verwenden ist.

In einem Verfahrensschritt S11 werden die gültigen Messabläufe und/oder die gemäß der Gewichtung oder Gewichtungen der Randbedingungen erzeugten Listen ausgegeben, vorliegend auf der Anzeige 6 angezeigt. In einem Verfahrensschritt S12 erfolgt eine Auswahl eines der gültigen Messabläufe als für die Untersuchung des Patienten 3 zu verwendender Messablauf. Der Verfahrensschritt S12 bedeutet ein automatisches Auswählen des zu verwendenden Messablaufs durch die Berechnungseinrichtung 4.

Insgesamt zeigen die beschriebenen Ausführungsbeispiele, wie Überschreitungen der Grenzwerte für die SAR und die Gradientenstimulation oder Slew Rate bei einer MRT-Untersuchung besonders effektiv, mit hohem Automationsgrad und besonders geringen Einschränkungen oder Nachteilen hinsichtlich der Bildqualität und/oder der benötigten Messzeit gelöst, also vermieden werden können.

## Patentansprüche

1. Verfahren (1) zum Betreiben einer MRT-Anlage, mit den Verfahrensschritten (S1-S12)
- Vorgeben (S1) eines geplanten Messablaufs zum Untersuchen eines Untersuchungsobjekts (3),
- für das Untersuchungsobjekt (3) mittels einer Berechnungseinrichtung (4) der MRT-Anlage (1) Berechnen (S3) einer bei Verwendung des geplanten Messablaufs voraussichtlich auftretenden spezifischen Absorptionsrate, die durch eine in das Untersuchungsobjekt (3) eingestrahlte Hochfrequenzleistung bestimmt ist, und/oder Bestimmen (S3) einer bei Verwendung des geplanten Messablaufs voraussichtlich auftretenden Gradientenstimulation, die durch eine Änderungsrate eines magnetischen Gradientenfeldes in dem Untersuchungsobjekt (3) erzeugt wird,
- falls die Berechnung für den geplanten Messablauf ein Überschreiten eines jeweiligen vorgegebenen Grenzwertes für die spezifische Absorptionsrate und/oder die Gradientenstimulation ergibt (S4), automatisches Erzeugen (S6) eines geplanten modifizierten Messablaufs durch automatisches Modifizieren (S6) des bisherigen geplanten Messablaufs mittels der Berechnungseinrichtung (4) unter Einhaltung wenigstens einer von einem Unterschreiten des jeweiligen Grenzwertes verschiedenen vorgegebenen (S2) Randbedingung, welche wenigstens ein minimal zu erfüllendes Kriterium für den modifizierten Messablauf spezifiziert,
- automatisches iteratives Durchführen des Berechnens (S3) der für den jeweiligen modifizierten Messablauf voraussichtlich auftretenden spezifischen Absorptionsrate und/oder Gradientenstimulation und des automatischen Erzeugens (S6) zumindest bis das Berechnen (S3) ergibt, dass der aktuelle modifizierte Messablauf den jeweiligen vorgegebenen Grenzwert nicht überschreitet,
- Ausgeben (S11) wenigstens des aktuellen modifizierten Messablaufs, der gemäß der Berechnung (S3) voraussichtlich nicht zum Überschreiten des jeweiligen vorgegebenen Grenzwertes führt und der die wenigstens eine vorgegebene Randbedingung erfüllt,
**dadurch gekennzeichnet, dass**
- mehrere modifizierte Messabläufe bestimmt werden (S6), die jeweils voraussichtlich nicht zum Überschreiten des jeweiligen Grenzwertes führen, und
- in Abhängigkeit von der wenigstens einen vorgegebenen Randbedingung automatisch derjenige der bestimmten modifizierten Messabläufe, der den höchsten Erfüllungsgrad oder Übererfüllungsgrad bezüglich der wenigstens einen vorgegebenen Randbedingung aufweist, zur Verwendung ausgewählt wird (S12) .

2. Verfahren (1) nach Anspruch 1, **dadurch gekennzeichnet, dass** als die wenigstens eine Randbedingung ein minimal abzubildendes Volumen und/oder eine minimale Auflösung, mit der das Untersuchungsobjekt (3) abzubilden ist, und/oder eine maximale Messzeit für den Messablauf und/oder ein Zeitpunkt einer Kontrastmitteleinbringung in das Untersuchungsobjekt (3) und/oder eine einzuhaltende Echozeit und/oder eine Repetitionszeit vorgegeben werden (S2).

3. Verfahren (1) nach einem der vorhergehenden Ansprüche, **dadurch gekennzeichnet, dass** zum Modifizieren (S6) des jeweiligen, mehrere nacheinander auszuführende Sequenzen umfassenden Messablaufs eine Sequenzreihenfolge geändert und/oder wenigstens eine Sequenz gegen eine in einer Datenbank hinterlegte Alternativsequenz ausgetauscht wird, die in wenigstens einer Wirkung der ersetzten Sequenz entspricht.

4. Verfahren (1) nach Anspruch 3, **dadurch gekennzeichnet, dass** die Alternativsequenz automatisch ausgewählt wird in Abhängigkeit von der wenigstens einen vorgegebenen Randbedingung, die die Wirkung, in der sich die ersetzte Sequenz und die Alternativsequenz entsprechen sollen, bestimmt.

5. Verfahren (1) nach einem der vorhergehenden Ansprüche, **dadurch gekennzeichnet, dass** zum Modifizieren (S6) des jeweiligen Messablaufs automatisch eine Charakteristik eines oder mehrerer Pulse des Messablaufs modifiziert wird, insbesondere hinsichtlich eines Pulstyps und/oder einer Pulsdauer und/oder einer Pulsamplitude.

6. Verfahren (1) nach einem der vorhergehenden Ansprüche, **dadurch gekennzeichnet, dass** zum Modifizieren (S6) des jeweiligen Messablaufs aufeinander abgestimmt eine Anzahl von abgebildeten Schichten reduziert, eine Schichtdicke der abgebildeten Schichten erhöht, eine Anzahl von Phasenkodierschritten reduziert und eine Basisauflösung reduziert werden.

7. Verfahren (1) nach einem der vorhergehenden Ansprüche, **dadurch gekennzeichnet, dass** zum Modifizieren (S6) des jeweiligen Messablaufs eine darin vorgesehener Flipwinkel reduziert wird.

8. Verfahren (1) nach einem der vorhergehenden Ansprüche, **dadurch gekennzeichnet, dass** zum Modifizieren (S6) des jeweiligen Messablaufs einerseits eine Auslesebandbreite der MRT-Anlage (1) verändert und andererseits darauf abgestimmt ein partieller Fourier-Faktor erhöht oder eine Anzahl von Phasenkodierschritten reduziert werden.

9. Verfahren (1) nach einem der vorhergehenden Ansprüche, **dadurch gekennzeichnet, dass** das iterative automatische Modifizieren (S6) des jeweiligen Messablaufs anhand einer vorgegebenen Prioritätsliste durchgeführt wird, in der mit einer jeweiligen Priorität annotierte Modifikationen hinterlegt sind, wobei Modifikationen mit höherer Priorität bevorzugt vorgenommen werden.

10. Verfahren (1) nach einem der vorhergehenden Ansprüche, **dadurch gekennzeichnet, dass** automatisch wenigstens eine neue Randbedingung abgefragt wird (12, S2), falls nach einer vorgegebenen Anzahl von Iterationen kein modifizierter Messablauf erzeugt worden ist, der die bisherige wenigstens eine vorgegebene Randbedingung erfüllt und nicht zum Überschreiten des jeweiligen Grenzwertes führt.

11. Verfahren (1) nach einem der vorhergehenden Ansprüche, **dadurch gekennzeichnet, dass**
- mehrere Randbedingungen vorgegeben werden (S2),
- mehrere modifizierte Messabläufe bestimmt werden (S6), die jeweils voraussichtlich nicht zum Überschreiten des jeweiligen Grenzwertes führen, und
- die mehreren bestimmten modifizierten Messabläufe in Abhängigkeit von einer Gewichtung der Randbedingungen sortiert werden (S10).

12. MRT-Anlage (1) mit einer Eingangsschnittstelle (5) zum Erfassen wenigstens einer vorgegebenen Randbedingung, mit einer Ausgabeschnittstelle (6) und mit einer mit der Eingangsschnittstelle (5) und mit der Ausgabeschnittstelle (6) durch eine jeweilige Datenverbindung verbundenen Berechnungseinrichtung (4), umfassend einen Datenspeicher mit einem Programmcode, der ein Verfahren (1) gemäß einem der vorhergehenden Ansprüche kodiert, und eine mit dem Datenspeicher gekoppelte Prozessoreinrichtung zum Ausführen des Programmcodes.

## Claims

1. Method (1) for operating an MRT installation, with the method steps (S1-S12)
- predefining (S1) a planned measurement procedure for examining an examination object (3),
- calculating (S3), for the examination object (3), by means of a calculation facility (4) of the MRT installation (1), a specific absorption rate that is likely to occur when using the planned measurement procedure and is determined by a radiofrequency power irradiated into the examination object (3), and/or determining (S3) a gradient stimulation that is likely to occur when using the planned measurement procedure and is generated by a rate of change of a magnetic gradient field in the examination object (3),
- if the calculation for the planned measurement procedure results in (S4) an exceeding of a respective predefined limit value for the specific absorption rate and/or the gradient stimulation, then automatically generating (S6) a planned modified measurement procedure by automatically modifying (S6) the previous planned measurement procedure by means of the calculation facility (4) while maintaining at least one predefined (S2) boundary condition which is different from falling below the respective limit value and specifies at least one criterion to be fulfilled at a minimum for the modified measurement procedure,
- automatically iteratively performing the calculation (S3) of the specific absorption rate and/or gradient stimulation likely to occur for the respective modified measurement procedure and the automatic generation (S6) at least up to the calculation (S3) results in the current modified measurement procedure not exceeding the respective predefined limit value,
- outputting (S11) at least the current modified measurement procedure, which according to the calculation (S3) is not likely to lead to exceeding the respective predefined limit value and which fulfils the at least one predefined boundary condition,
**characterised in that**
- a plurality of modified measurement procedures are determined (S6), which in each case are not likely to lead to exceeding the respective limit value, and
- as a function of the at least one predefined boundary condition, the measurement procedure of the determined modified measurement procedures which has the highest level of fulfilment or level of over-fulfilment with regard to the at least one predefined boundary condition is automatically selected (S12) for use.

2. Method (1) according to claim 1, **characterised in that** a volume to be mapped at a minimum and/or a minimum resolution, with which the examination object (3) is to be mapped, and/or a maximum measurement time for the measurement procedure and/or a point in time of an introduction of contrast agent into the examination object (3) and/or an echo time to be complied with and/or a repetition time are predefined (S2) as the at least one boundary condition.

3. Method (1) according to one of the preceding claims, **characterised in that** in order to modify (S6) the respective measurement procedure that comprises a plurality of sequences to be carried out in succession, a sequence order is changed and/or at least one sequence is swapped with an alternative sequence stored in a database, which corresponds to the replaced sequence in at least one effect.

4. Method (1) according to claim 3, **characterised in that** the alternative sequence is selected automatically as a function of the at least one predefined boundary condition, which determines the effect in which the replaced sequence and the alternative sequence are to correspond.

5. Method (1) according to one of the preceding claims, **characterised in that** in order to modify (S6) the respective measurement procedure a characteristic of one or more pulses of the measurement procedure is modified automatically, in particular with regard to a pulse type and/or a pulse duration and/or a pulse amplitude.

6. Method (1) according to one of the preceding claims, **characterised in that** in order to modify (S6) the respective measurement procedure, in a manner coordinated with one another, a number of slices to be mapped is reduced, a slice thickness of the mapped slices is increased, a number of phase encoding steps is reduced and a base resolution is reduced.

7. Method (1) according to one of the preceding claims, **characterised in that** in order to modify (S6) the respective measurement procedure a flip angle provided therein is reduced.

8. Method (1) according to one of the preceding claims, **characterised in that** in order to modify (S6) the respective measurement procedure, on the one hand a readout bandwidth of the MRT installation (1) is altered and on the other hand, in a manner coordinated therewith, a partial Fourier factor is increased or a number of phase encoding steps is reduced.

9. Method (1) according to one of the preceding claims, **characterised in that** the iterative automatic modification (S6) of the respective measurement procedure is performed on the basis of a predefined priority list, in which modifications annotated with a respective priority are stored, wherein modifications with higher priority are made with preference.

10. Method (1) according to one of the preceding claims, **characterised in that** at least one new boundary condition is queried (12, S2) automatically, if no modified measurement procedure that fulfils the previous at least one predefined boundary condition and does not lead to exceeding of the respective limit value has been generated after a predefined number of iterations.

11. Method (1) according to one of the preceding claims, **characterised in that**
- a plurality of boundary conditions are predefined (S2),
- a plurality of modified measurement procedures are determined (S6), which in each case are not likely to lead to exceeding of the respective limit value, and
- the plurality of determined modified measurement procedures are sorted (S10) as a function of a weighting of the boundary conditions.

12. MRT installation (1) with an input interface (5) for detecting at least one predefined boundary condition, with an output interface (6) and with a calculation facility (4) connected to the input interface (5) and to the output interface (6) by way of a respective data connection, comprising a data storage unit with a program code that encodes a method (1) according to one of the preceding claims, and a processor facility coupled to the data storage unit for executing the program code.

## Revendications

1. Procédé (1) pour faire fonctionner une installation IRM, comprenant les stades (S1 à S12) de procédé
- on prescrit (S1) un déroulement planifié de mesure pour l'examen d'un objet (3) à examiner,
- pour l'objet (3) à examiner, on calcule (S3), au moyen d'un dispositif (4) de calcul de l'installation (1) IRM, un taux d'absorption spécifique se produisant probablement lors de l'utilisation du déroulement planifié de la mesure et déterminé par une puissance de haute fréquence incidente dans l'objet (3) à examiner et/ou on détermine (S3) une stimulation de grandient se produisant probablement lors de l'utilisation du déroulement planifié de la mesure et produite par un taux de variation d'un champ de grandient magnétique dans l'objet (3) à examiner,
- si le calcul du déroulement planifié de la mesure donne (S4), un dépassement d'une valeur limite respective donnée à l'avance du taux d'absorption spécifique et/ou de la stimulation de grandient, on produit (S6) automatiquement un déroulement planifié modifié de la mesure en modifiant (S6) automatiquement le déroulement planifié de la mesure jusqu'ici, au moyen du dispositif (4) de calcul, en maintenant au moins une condition limite donnée à l'avance (S2), qui est différente d'un dépassement par le bas de la valeur limite respective et qui spécifie au moins un critère minimum à remplir pour le déroulement modifié de la mesure,
- on effectue itérativement automatiquement le calcul (S3) du taux d'absorption spécifique et/ou de la stimulation de grandient, se produisant probablement pour le déroulement respectif modifié de la mesure, et de la production (S6) automatique, au moins jusqu'à ce que le calcul (S3) donne que le déroulement modifié en cours de la mesure ne dépasse pas la valeur limite respective donnée à l'avance,
- on émet (S11), au moins un déroulement modifié en cours de la mesure, qui suivant le calcul (S3) ne conduit probablement pas à un dépassement de la valeur limite respective donnée à l'avance et qui satisfait la au moins une condition limite donnée à l'avance,
**caractérisé en ce que**
- on détermine (S6) plusieurs déroulements modifiés de la mesure, qui chacun ne conduisent probablement pas au dépassement de la valeur limite respective, et
- en fonction de la au moins une condition limite donnée à l'avance, on choisit (S12) pour l'utilisation automatiquement celui des déroulements modifiés déterminés de la mesure, qui a le degré de satisfaction ou de sur-satisfaction le plus grand de la au moins une condition limite donnée à l'avance.

2. Procédé (1) suivant la revendication 1, **caractérisé en ce que** l'on prescrit (S2) comme, la au moins une condition aux limites, un volume minimum à constituer et/ou une résolution minimum avec laquelle l'objet (3) à examiner est à reproduire et/ou un temps de mesure maximum du déroulement de la mesure et/ou un instant d'une introduction d'un agent de contraste dans l'objet (3) à examiner et/ou un temps d'écho à observer et/ou un temps de répétition.

3. Procédé (1) suivant l'une des revendications précédentes, **caractérisé en ce que**, pour la modification (S6) du déroulement de la mesure respectif comprenant plusieurs séquences à exécuter les unes après les autres, on modifie une succession de séquences et/ou on remplace au moins une séquence par une séquence alternative mise dans une base de données, qui correspond à au moins un effet de la séquence remplacée.

4. Procédé (1) suivant la revendication 3, **caractérisé en ce que** l'on choisit automatiquement la séquence alternative, en fonction de la au moins une condition aux limites données à l'avance, qui détermine l'effet, par lequel la séquence remplacée et la séquence alternative doivent se correspondre.

5. Procédé (1) suivant l'une des revendications précédentes, **caractérisé en ce que**, pour la modification (S6) du déroulement respectif de la mesure, on modifie automatiquement une caractéristique d'une ou plusieurs impulsions du déroulement de la mesure, notamment en ce qui concerne un type d'impulsion et/ou une durée d'impulsion et/ou une amplitude d'impulsion.

6. Procédé (1) suivant l'une des revendications précédentes, **caractérisé en ce que**, pour la modification (S6) du déroulement respectif de la mesure, on effectue, d'une manière adaptée les unes aux autres, une réduction du nombre de tranches reproduites, une augmentation de l'épaisseur des tranches reproduites, une réduction du nombre de stades de codage de phases et une réduction de la résolution de base.

7. Procédé (1) suivant l'une des revendications précédentes, **caractérisé en ce que**, pour la modification (S6) du déroulement respectif de la mesure, on réduit un angle de flip, qui y est prévu.

8. Procédé (1) suivant l'une des revendications précédentes, **caractérisé en ce que**, pour la modification (S6) du déroulement respectif de la mesure, d'une part on modifie une largeur de bande de lecture de l'installation (1) IRM et d'autre part, de manière adaptée, on augmente un facteur de Fourier partiel ou on réduit un nombre de stades de codage de phases.

9. Procédé (1) suivant l'une des revendications précédentes, **caractérisé en ce que** l'on effectue la modification (S6) automatique itérative du déroulement respectif de la mesure à l'aide d'une liste de priorité donnée à l'avance, dans laquelle sont mises des modifications annotées d'une priorité respective, des modifications de priorité plus grande étant effectuées de préférence.

10. Procédé (1) suivant l'une des revendications précédentes, **caractérisé en ce que** l'on demande (12, S2) automatiquement au moins une nouvelle condition aux limites, si après un nombre donné à l'avance d'itérations, il n'a pas été produit de déroulement modifié de la mesure, qui satisfait la au moins une condition aux limites données à l'avance jusqu'ici et qui n'entraîne pas le dépassement de la valeur limite respective.

11. Procédé (1) suivant l'une des revendications précédentes, **caractérisé en ce que**
- on prescrit (S2) plusieurs conditions aux limites,
- on détermine (S6) plusieurs déroulements modifiés de la mesure, qui ne conduisent chacun probablement pas au dépassement de la valeur limite respective, et
- on trie (S10) les plusieurs déroulements modifiés déterminés de la mesure en fonction d'une pondération des conditions aux limites.

12. Installation (1) IRM comprenant une interface (5) d'entrée, pour la saisie d'au moins une conditions aux limites donnée à l'avance, comprenant une interface (6) de sortie et comprenant un dispositif (4) de calcul, relié à l'interface (5) d'entrée et à l'interface (6) de sortie par une liaison de données respective, comprenant une mémoire de données ayant un code de programme, qui code un procédé (1) suivant l'une des revendications précédentes et un dispositif de processeur, relié à la mémoire de données, pour l'exécution du code de programme.
